# EUROPEAN PATENT APPLICATION

(11) **EP 1 492 119 A2**
(43) Date of publication of application: **29.12.2004**
(21) Application number: 04014744.9
(22) Date of filing: 23.06.2004
(51) Int. Cl.: G11B 33/12, G11B 33/14

(54) **DVD apparatus**

(30) Priority: 24.06.2003 JP 2003179727
(71) Applicant: Funai Electric Co., Ltd., Daito-shi, Osaka (JP)
(72) Inventor: Higuchi, Yoshio, Daito-shi Osaka (JP)
(74) Representative: Grünecker, Kinkeldey, Stockmair & Schwanhäusser Anwaltssozietät

(57) **Abstract**

In a configuration where a circuit board is divided into a digital circuit board (40) and a power supply circuit board (30) arranged at respective sides of an optical disk loader (20), the level of unwanted emission is reduced significantly by modifying the division of grounding patterns of the digital circuit board (40), and arranging a filter on the digital circuit board (40) adjacent to connectors (46-48). Accordingly, a metal case is dispensable, and a resin case can be employed. Therefore, the cost of a DVD apparatus can be reduced.

## Description

### BACKGROUND OF THE INVENTION

### Field of the Invention

The present invention relates to a DVD (Digital Versatile Disc) apparatus.

### Description of the Background Art

The technical approach of allowing the color and shape of the appearance of an electrical apparatus such as a video tape player with a front loading mechanism to suit the user's preference by using a top cover of a cabinet made of synthetic resin that was conventionally made of metal is disclosed in Japanese Utility Model Registration No. 3011944.

The aforementioned conventional approach has a metal shield plate inserted for electromagnetic shielding to prevent electromagnetic interference (EMI). Conventional apparatuses with an appearance of a synthetic resin cabinet took countermeasures against electromagnetic radiation by incorporating the aforementioned shield plate or inserting a metal case inside the resin-made cabinet.

With regards to the electric field intensity of unwanted emission (also termed unwanted electromagnetic radiation, electromagnetic field leakage, and the like) in Japan, a voluntary limit is defined for VCCI (Voluntary Control Council for Interference by Data Processing Equipment and Electronic Office Machine). The limit value for EMI restriction is defined on a country-by-country basis abroad. Therefore, the electric field intensity of unwanted emission in a product must be suppressed below the limit value set at the country where that product is used. The problem of unwanted emission is more acute in digital signal processing than in analog signal processing since more harmonics are generated during the processing of digital signals.

In apparatuses recording and reproducing analog signals directly such as in conventional video cassette recorders (VCR), the fundamental frequency of a digital signal corresponds to the operating frequency of the microcomputer for control. In a VCR, the operating frequency of such a microcomputer is approximately 12 MHz

A DVD apparatus has images and sound recorded in digital signals, requiring processing of multibit digital signals, as well as encode and decode processing of MPEG (Motion Picture Experts Group) and the like by means of a memory. Therefore, digital signals are processed at a higher rate than in VCRs. In DVD apparatuses, the operating frequency of the signal processing system is as high as 54 MHz, and the operating frequency of the memory is as high as 120 MHz

Consider a ten fold harmonic, for example, as the harmonic corresponding to the problem of unwanted emission. In a VCR, 12 (MHz) × 10 (times) = 120 (MHz). For a DVD apparatus, 102 (MHz) × 10 (times) = 1200 (MHz). In other words, harmonics of a frequency ten times that of the VCR will become problematic as unwanted emission in DVD apparatuses.

In the United States, for example, the limit of unwanted emission is defined to 43.5dB in frequency bands below 220MHz, to 46.0dB in frequency bands of 220-540 MHz, and to 54dB in frequency bands above 540 MHz Although the limit will be alleviated as the frequency becomes higher, the effect of background noise and increase in antenna loss will become more significant. More careful means must be taken to suppress occurrence of unwanted emission as the frequency becomes higher. Otherwise, the limit will be exceeded.

Furthermore, since a DVD apparatus has a higher circuit operating frequency than a VCR, circuitry will respond too sensitively to impulse noise of an extremely small range that was of no concern in conventional VCRs. Many of such impulse noises originate from electric energy present in nature such as static electricity. For example, static electricity and the like will be introduced as radio waves to be received at regions other than the site where the static electricity is directly applied to cause high frequency noise. In this regard, the disadvantage of erroneous operation and the like may occur.

A metal case functions effectively to reduce the above-described unwanted emission and to provide protection from incident high frequency noise. Therefore, a metal case has been typically employed in conventional cases.

Specifically, a conventional DVD player has a rigid U-shape metal panel cover arranged on a metal base. The rear side is also made of metal. The front panel is formed of plastic so as to accommodate various designs. In other words, a conventional DVD player is generally cover with a metal panel on all sides except for the front.

Thus, in view of the above-described problems of unwanted emission and high frequency noise in DVD apparatuses, a resin case could not be used for a DVD apparatus as a substitute for a metal case that is disadvantageous from the standpoint of cost as compared to a resin case.

### SUMMARY OF THE INVENTION

An object of the present invention is to provide a DVD apparatus competitive in cost by employing a resin case.

According to an aspect of the present invention, a DVD apparatus includes a first printed circuit board mounted with a power supply circuit that provides a direct power supply voltage used internally, an optical disk loader including a pick up unit to read out information of an optical disk, a second printed circuit board mounted with a digital circuit receiving supply of the direct current power supply voltage from the first printed circuit board to carry out a reproduction process of a video signal and an audio signal on a signal read out from the pick up unit, and providing control of a system, and a resin case storing the first printed circuit board, the optical disk loader, and the second printed circuit board.

Preferably, a system LSI integrated with a digital circuit that carries out the reproduction process and that carries out the control of a system is mounted on the surface side of the second printed circuit board. The second printed circuit board includes a grounding pattern arranged so as to overlap with at least the mounted region of the system LSI.

Further preferably, the grounding pattern is formed at an intermediate conductor layer between the surface side and back side of the second printed circuit board.

Preferably, the optical disk loader further includes a motor to rotate the optical disk. The second printed circuit board further includes a memory connected to the system LSI and a motor driver driving the motor. The grounding pattern applies a common ground potential to the system LSI, the memory, and the motor driver.

Preferably, the second printed circuit board is of a shape having two pairs of opposite sides, and mounted with a system LSI integrated with a digital circuit that carries out a reproduction process and that provides control of the system. The mounting position of the system LSI on the second printed circuit board is located closer to a first side than a second side, both first and second sides constituting one of the two pairs. The second printed circuit board is further mounted with a connector provided along the second side to establish electrical connection with the first printed circuit board.

Preferably, the DVD apparatus further includes a connector provided on the second printed circuit board, and a signal line connected to the connector. The second printed circuit board includes a region to arrange a filter, adjacent to a terminal of the connector connected to the signal line to inhibit radiation of unwanted emission caused by a high frequency signal issued from the digital circuit.

Preferably, the optical disk loader is arranged at the center region, and the first and second printed circuit boards are arranged at respective sides of the optical disk loader.

A main advantage of the present invention is to significantly reduce the level of unwanted emission by dividing the circuit board into a digital circuit board and a power supply circuit board. Accordingly, a metal case is dispensable, allowing the usage of a resin case. Therefore, the cost of a DVD apparatus can be reduced.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a whole block diagram of a DVD apparatus of the present invention.
Fig. 2 is a front view of a DVD apparatus of the present invention.
Fig. 3 shows an arrangement of circuit boards and an optical disk loader of the DVD apparatus of the present invention.
Fig. 4 shows an arrangement of main IC components at the surface side of a digital circuit board in an evaluation example.
Fig. 5 is a perspective illustration of an arrangement of main components at the back side of a digital circuit board in an evaluation example, viewed from the surface side.
Fig. 6 shows a grounding pattern of the digital circuit board in the evaluation example.
Fig. 7 shows a power supply pattern of the digital circuit board in the evaluation example.
Fig. 8 represents the level of unwanted emission of a DVD apparatus when the digital circuit board of the evaluation example is employed.
Fig. 9 shows the arrangement of main IC components at the surface side of a digital circuit board of the present invention.
Fig. 10 is a perspective illustration of an arrangement of main components at the back side of the digital circuit board of the present invention, viewed from the surface side.
Fig. 11 is a diagram to describe the type of filters arranged at filter arrange regions of Fig. 10.
Fig. 12 shows a grounding pattern of a digital circuit board in the present invention.
Fig. 13 shows a power supply pattern of a digital circuit board in the present invention.
Fig. 14 represents the level of unwanted emission of a DVD apparatus when the digital circuit board of the present invention is used.

### DESCRIPTION OF THE PREFERRED EMBODIMENT

Embodiments of the present invention will be described in detail hereinafter with reference to the drawings. In the drawings, the same reference character represents the same or corresponding element.

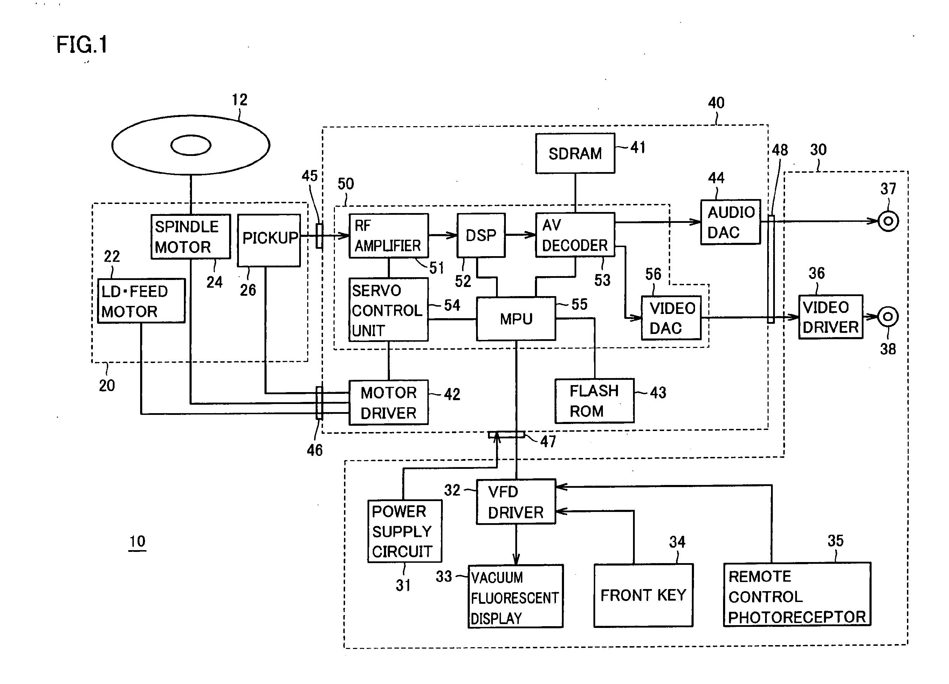

Fig. 1 is a whole block diagram of a DVD apparatus of the present invention.

Referring to Fig. 1, a DVD apparatus 10 includes an optical disk loader 20 to set an optical disk 12, a digital circuit board 40 to process a signal read out from optical disk 12 sent from optical disk loader 20, and a power supply circuit board 30 supplying power to digital circuit board 40.

Optical disk loader 20 includes a spindle motor 24 to rotate optical disk 12, a pickup 26 to direct a beam onto an optical disk to read out information, and an LD·feed motor 22 to load a tray for mounting an optical disk not shown and move pickup 26 corresponding to a readout position.

Digital circuit board 40 includes a system LSI 50 having a front end processing circuit temporarily demodulating a modulated signal from the pickup to form a bit stream, an MPEG (Motion Picture Experts Group) demodulator circuit and a system control microprocessor integrated in one package, an SDRAM (Synchronous Dynamic Random Access Memory) 41 connected to system LSI 50, a flash ROM (Read Only Memory) 43, a motor driver 42, and an audio DAC (Digital-to-Analog Converter) 44.

System LSI 50 includes an RF amplifier 51 receiving a signal read out from pickup 26, a DSP (Digital Signal Processor) 52 converting the outputs of RF amplifier 51 into a bit stream, an AV decoder 53 decoding the output from DSP 52 into a digital audio signal and video signal, a servo control unit 54 driving motor driver 42 according to an output of RF amplifier 51, and an MPU (Micro Processing Unit) 55 connected to servo control unit 54, DSP 52 and AV decoder 53 to provide entire control of the system.

System LSI 50 further includes a video DAC 56 to convert a digital video signal output from AV decoder 53 into an analog signal.

SDRAM 41 is connected to AV decoder 53 to be used as a working memory for the MPEG demodulation process. Flash ROM 43 is connected to MPU 55, and has a program for system control stored therein. Motor driver 42 outputs a driving signal to LD·feed motor 22, spindle motor 24 and pickup 26 under control of servo control unit 54.

Audio DAC 44 converts a digital audio signal output from AV decoder 53 into an analog audio signal.

Power supply circuit board 30 includes a power supply circuit 31 generating and supplying to digital circuit board 40 a stabilized direct current power supply voltage based on an externally applied alternating current power supply, a vacuum fluorescent display (VFD) 33 displaying a reproduction status of the optical disk, a front key 34 to designate playback and stop of an optical disk, a remote control photoreceptor 35 receiving infrared radiation from a remote controller in controlling the operation of an optical disk by remote control operation, and a VFD driver 32 connected to vacuum fluorescent display 33, front key 34 and remote control photoreceptor 35 to drive the VFD under control of MPU 55.

Power supply circuit board 30 further includes an audio output terminal 37 to provide the output from audio DAC 44 outside, a video driver 36 receiving an output of video DAC 56, and a video output terminal 38 to output a video signal from video driver 36.

Digital circuit board 40 further includes connectors 45-48. Connector 45 is connected with a signal line to transmit a signal from pickup 26 to RF amplifier 51. Connector 46 is connected with a signal line connecting LD·feed motor 22, spindle motor 24 and pickup 26 with motor driver 42. Connector 47 is connected with a power supply line supplying power from power supply circuit 31 to digital circuit board 40 and a control signal line connecting MPU 55 and VFD driver 32. Connector 48 is connected with a signal line transmitting the output of audio DAC 44 to output terminal 37 and transmitting the output of video DAC 56 to video driver 36.

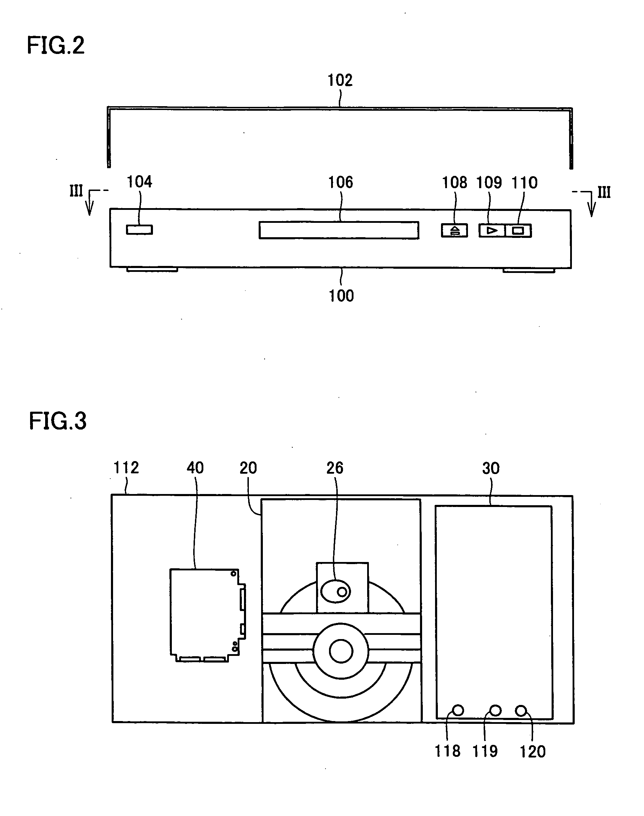

Fig. 2 is a front view of the DVD apparatus of the present invention.

Referring to Fig. 2, a front panel 100 has a power switch 104, a playback button 109, a stop button 110, and an eject button 108 arranged. Upon operation of eject button 108, a tray on which an optical disk is to be mounted is ejected frontwards from a loading opening 106.

The DVD apparatus is covered with a resin case 102. By employing the configuration that will be described sequentially hereinafter, the DVD apparatus of the present invention can lower the level of unwanted emission, and can use a resin case 102 for the casing. Accordingly, the cost of the DVD apparatus can be reduced significantly. When in use, resin case 102 is fit at the chassis case base plate. For the sake of convenience, Fig. 2 corresponds to the state where resin case 102 is detached above the chassis.

Fig. 3 shows an arrangement of the circuit board and the optical disk loader in the DVD apparatus of the present invention.

Fig. 3 corresponds to a plan view of the DVD apparatus viewed from the plane of III-III of Fig. 2. On a chassis case base plate 112 are arranged digital circuit board 40, optical disk loader 20, and power supply circuit board 30. Optical disk loader 20 is arranged at the central region with digital circuit board 40 and power supply circuit board 30 at respective sides. At the front panel side of power supply circuit board 30 are arranged switches 118, 119 and 120 corresponding to buttons 108, 109 and 110, respectively, of Fig. 2.

At the center of optical disk loader 20, pickup 26 is arranged in a movable manner from the center towards the outer circumference of an optical disk.

Although an arrangement of digital circuit board 40, optical disk loader 20, and power supply circuit board 30 currently considered to be the best is shown, the characterizing feature is that the digital circuit board is separated from the power supply circuit board. Alternatively, digital circuit board 40 may be placed on power supply circuit board 40, and arranged beside optical disk loader 20.

### Evaluation Example

There are various measures to cope with the problem of unwanted emission. It is extremely difficult even for one skilled in the art to select and employ an appropriate combination of respective measures due to constraints such as the cost, dimension, and the like to produce a product. The inventors of the present invention were able to reduce unwanted emission by conducting a range of evaluation to reduce unwanted emission. One of such an evaluation example will be described hereinafter.

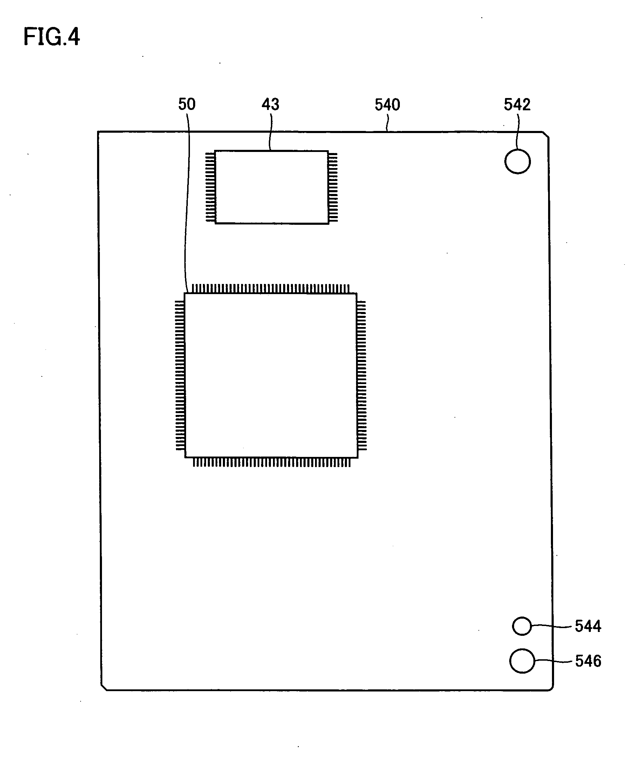

Fig. 4 shows the arrangement of main IC components at the surface side of a digital circuit board in the evaluation example.

Referring to Fig. 4, system LSI 50 and flash ROM 43 of Fig. 1 are arranged at the surface side of a digital circuit board 540 of the evaluation example. Further, a positioning hole 544 and screw holes 542 and 546 for fixation are provided at digital circuit board 540.

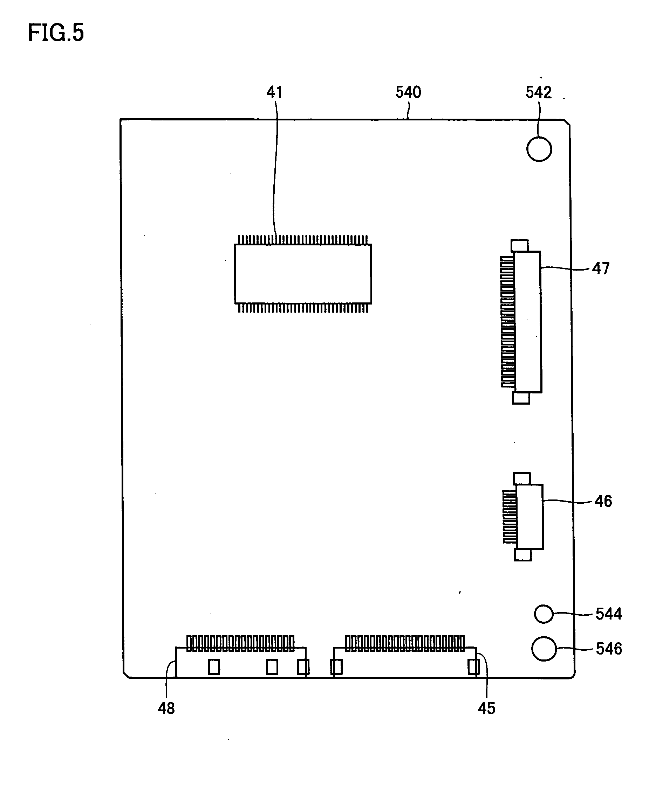

Fig. 5 is a perspective illustration of the arrangement of main components at the back side of the digital circuit board of the evaluation example, viewed from the surface side.

Referring to Fig. 5, SDRAM 41 of Fig. 1 is arranged at digital circuit board 540 with connectors 45-48 of Fig. 1 at the peripheral region. By superposing Figs. 4 and 5 so that positioning hole 544 and screw holes 452 and 546 match each other, the relationship of the arrangement between the components at the surface side and the components at the back side can be understood.

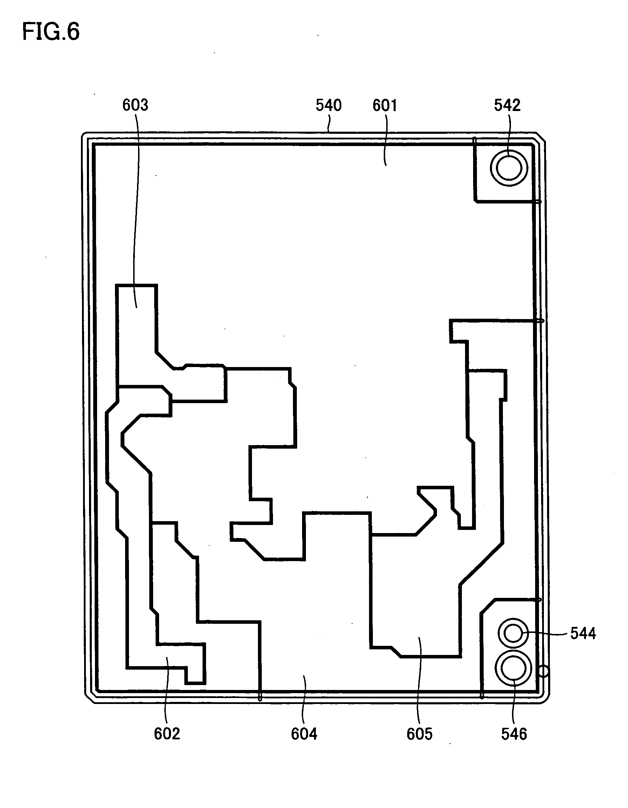

Fig. 6 shows the grounding pattern of the digital circuit board in the evaluation example.

Referring to Fig. 6, the grounding pattern is formed at a conductor layer provided intermediate the surface side and back side of digital circuit board 540. The grounding pattern is divided into five patterns 601-605. Although through holes for the connection of upper and lower conductor layers are provided in the grounding pattern, the through holes are not depicted for the sake of convenience.

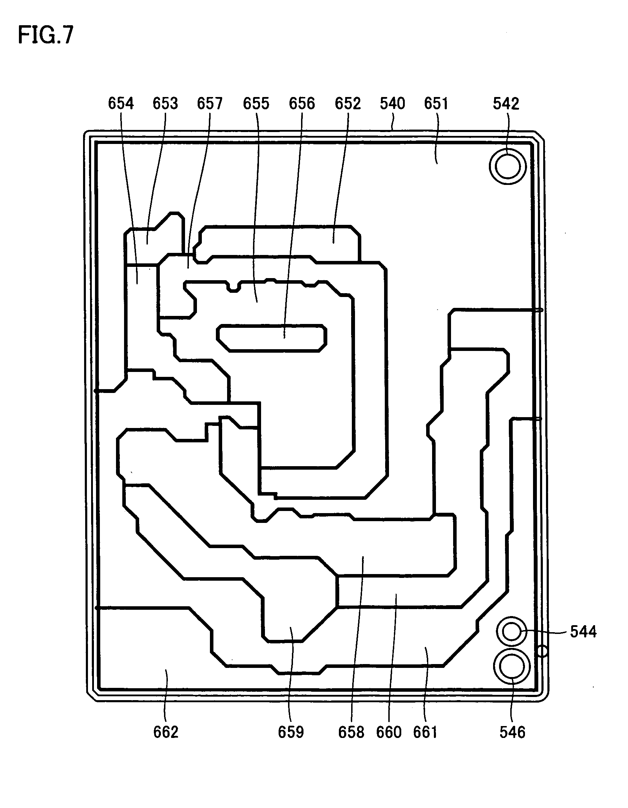

Fig. 7 shows the power supply pattern of the digital circuit board in the evaluation example.

Referring to Fig. 7, the power supply pattern is formed at an intermediate layer provided intermediate the surface side and back side of digital circuit board 540, differing from that of the grounding pattern. The power supply pattern is divided into twelve patterns 651-662. Although through holes are provided for the connection of upper and lower conductor layers in the power supply pattern, the through holes are not depicted for the sake of convenience.

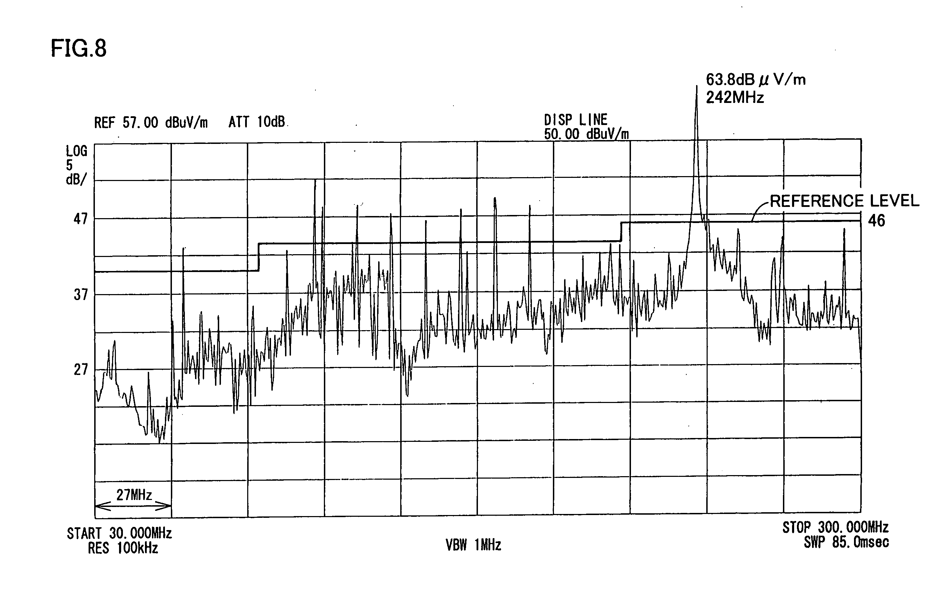

Fig. 8 shows the level of unwanted emission in an DVD apparatus corresponding to the case where the digital circuit board of the evaluation example is employed.

Referring to Fig. 8, several frequency points are identified, corresponding to detection of unwanted emission exceeding the reference level. It is to be particularly noted that, at the frequency of 242 MHz, the unwanted emission of 63.8 (dBµ V/m) greatly exceeding the reference level of 46 (dBµV/m) is detected.

### Digital Circuit Board of Present Invention

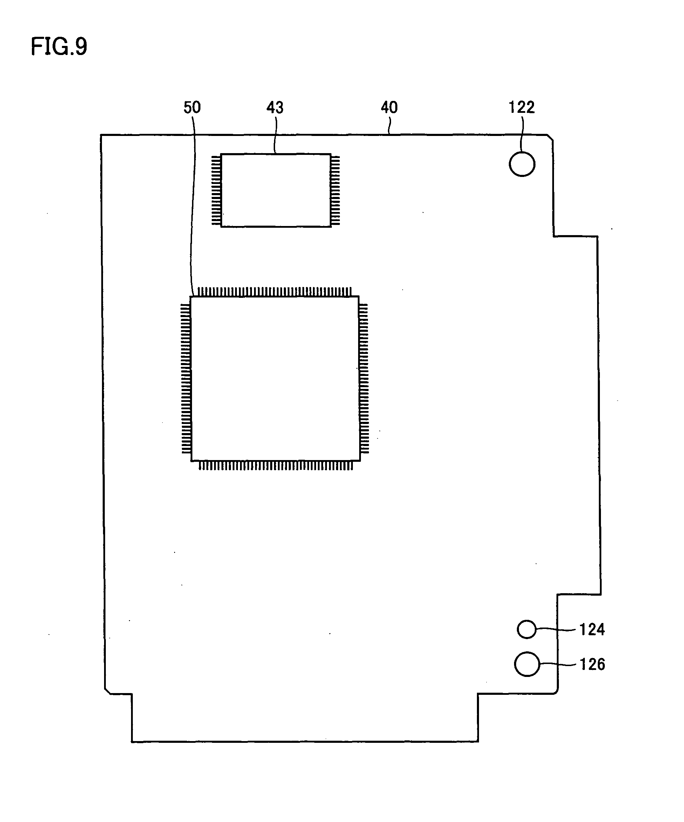

Fig. 9 shows an arrangement of main IC components at the surface side of the digital circuit board of the present invention.

Referring to Fig. 9, mainly system LSI 50 and flash ROM 43 of Fig. 1 are arranged at the surface of digital circuit board 40. A positioning hole 124 and screw holes 122 and 126 for fixation are provided at digital circuit board 40. Digital circuit board 40 is partially enlarged in size to evaluate the arrangement of filters that will be described afterwards, as compared to digital circuit board 540 of Fig. 4.

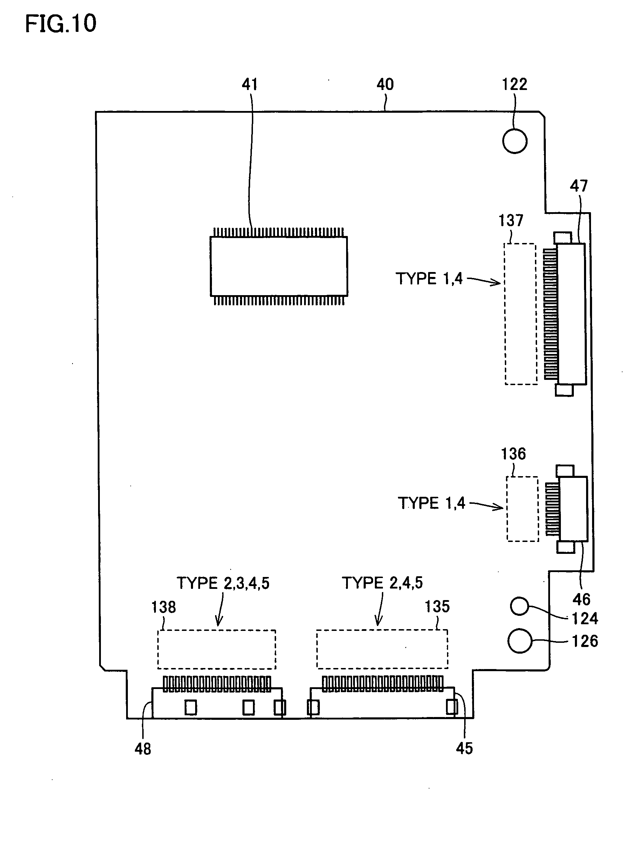

Fig. 10 is a perspective illustration of the arrangement of main components at the back side of the digital circuit board of the present invention, viewed from the surface side.

Referring to Fig. 10, a SDRAM (Synchronous Dynamic Random Access Memory) 41 and connectors 45-48 are arranged on digital circuit board 40, similar to the example of Fig. 5. In the digital circuit board of Fig. 10, there are provided filter arrange regions 135, 136, 137, and 138 adjacent to connectors 45, 46, 47 and 48, respectively, where filters are arranged to prevent an unwanted signal from being introduced into a connection line establishing connection between the digital circuit board and another circuit board or another circuit to be emitted. By superposing Figs. 9 and 10 so that positioning hole 124 and screw holes 122 and 126 respectively match each other, the relationship of the arrangement between the components at the surface side and the components at the back side can be understood.

Digital circuit board 40 has a shape including two pairs of opposite sides. The mounting position of system LSI 50 on digital circuit board 40 is located closer to a first side than a second side in Fig. 9. These opposite first and second sides constitute one of the pairs. In Fig. 10, digital circuit board 40 has connector 47 mounted along the second side, distant from the mounting position of system LSI 50. Connector 47 establishes electrical connection with the power supply circuit board. A similar relationship applies to the mounting position of the other one connector 48 directed to establishing electrical connection with the power supply circuit board and system LSI 50.

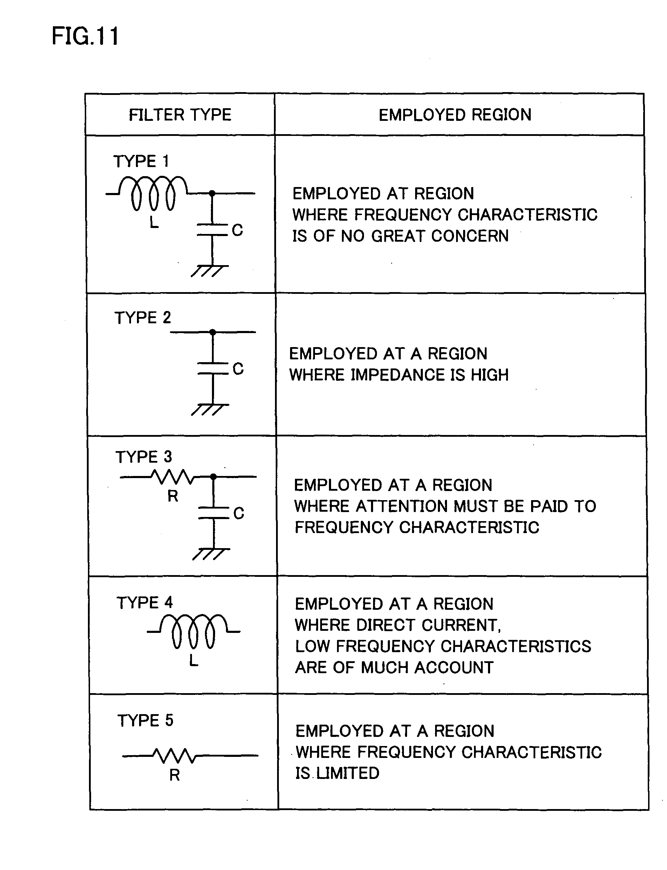

Fig. 11 is a diagram to describe the types of filters arranged at the filter arrange regions of Fig. 10.

The filters of types 1-4 will be described with reference to Fig. 11. Type 1 corresponds to an LC filter, employed at a region where the frequency characteristic is of no concern. Type 2 corresponds to a capacitor connected between a connection line and the grounding pattern, employed at a region where the impedance of the connection line is high. Type 3 corresponds to an RC filter, employed at a region where attention must be paid to the frequency characteristic. Type 4 corresponds to an inductance inserted in series with the connection line, employed at a region where direct current characteristic and low frequency characteristic are of much account.

Referring to Fig. 10 again, with respect to connector 45 to which is connected a signal line to transmit a signal from pickup 26 to RF amplifier 51 of Fig. 1, filters of types 2, 4 and 5 shown in Fig. 11 are arranged at filter arrange region 135 adjacent to thereto.

With respect to connector 46 establishing connection between motor driver 42 and optical disk loader 20 of Fig. 1, filters of types 1 and 4 of Fig. 11 are arranged at filter arrange region 136 adjacent to thereto. With respect to connector 47 establishing connection with power supply circuit 31 and VFD drivers 32, filters of types 1 and 4 of Fig. 11 are connected at filter arrange region 137 adjacent to thereto. With respect to connector 48 to transmit signals output from audio DAC 44 and video DAC 56 to terminal 37 and video driver 36, respectively, filters of types 2, 3, 4 and 5 of Fig. 11 are connected at filter arrange region 138 adjacent to thereto.

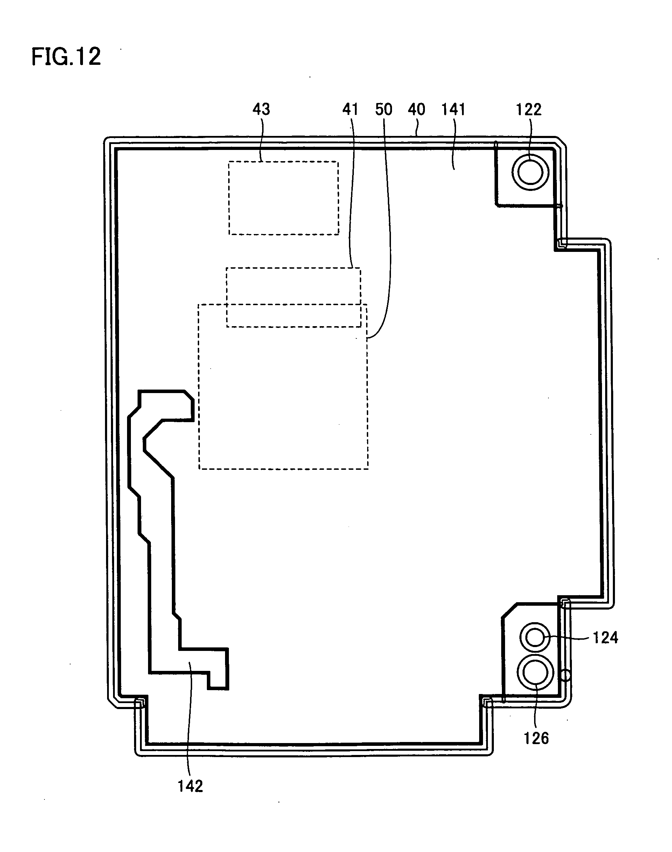

Fig. 12 shows the grounding pattern of the digital circuit board of the present invention.

Referring to Fig. 12, the grounding pattern is formed at an intermediate layer provided intermediate the surface side and back side of the digital circuit board. Digital circuit board 40 includes two grounding patterns 141 and 142. Although through holes to establish connection between the upper and lower conductor layers are provided at the grounding pattern, the through holes are not depicted for the sake of convenience.

In comparison with the grounding pattern of the evaluation example described with reference to Fig. 6, the four patterns of patterns 601, 603, 604, and 605 are integrated. For the sake of reference, the position of arrangement of system LSI 50, SDRAM 41 and flash ROM 43 is indicated by broken lines. It is appreciated that the region where system LSI 50 is arranged is completely covered with one grounding pattern 141. In other words, the system LSI is arranged on one grounding pattern that is not divided.

Grounding pattern 141 is depicted as an example where it is formed integrally at an intermediate layer. Alternatively, separate grounding patterns provided at two conductor layers may be connected by a through hole, and cover a region similar to grounding pattern 141.

By virtue of grounding pattern 141, the unwanted emission from system LSI 50 arranged at the surface side of digital circuit board 40 towards the back side of digital circuit board 40 can be blocked to reduce the level of unwanted emission as a whole.

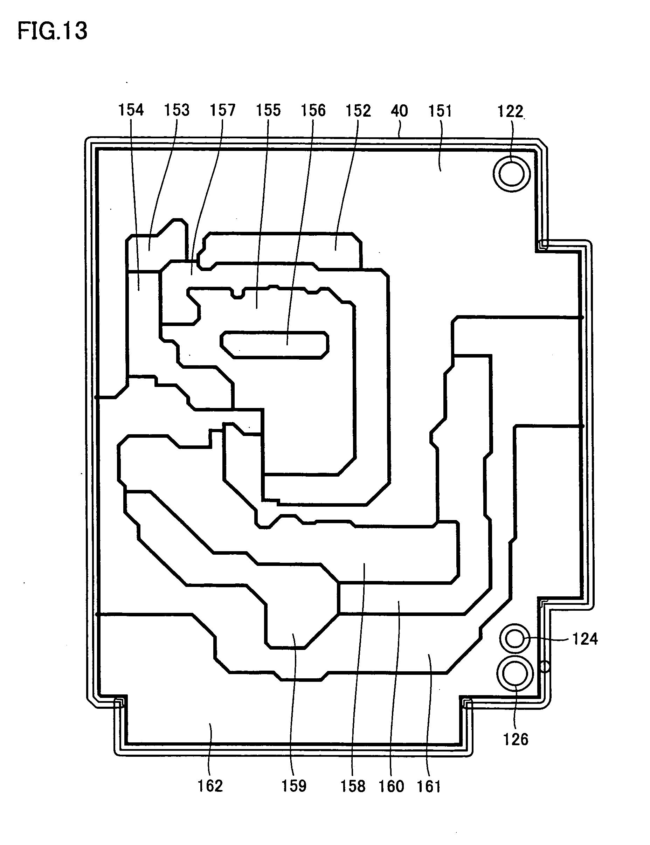

Fig. 13 shows a power supply pattern of the digital circuit board in the present invention.

Referring to Fig. 13, the power supply pattern is formed at an intermediate layer between the surface side and back side of digital circuit board 40, differing from the layer where the grounding pattern is formed. Although through holes to establish connection between the upper and lower conductor layers are provided at the power supply pattern, the through holes are not depicted for the sake of convenience.

In Fig. 13, the power supply pattern is divided into twelve power supply patterns 151-162. It is appreciated that this is similar to that of the evaluation example of Fig. 7. In other words, the power supply pattern is similar to that of the evaluation example, and the divided number of grounding patterns and the filter arrangement are modified in the digital circuit board of the present invention.

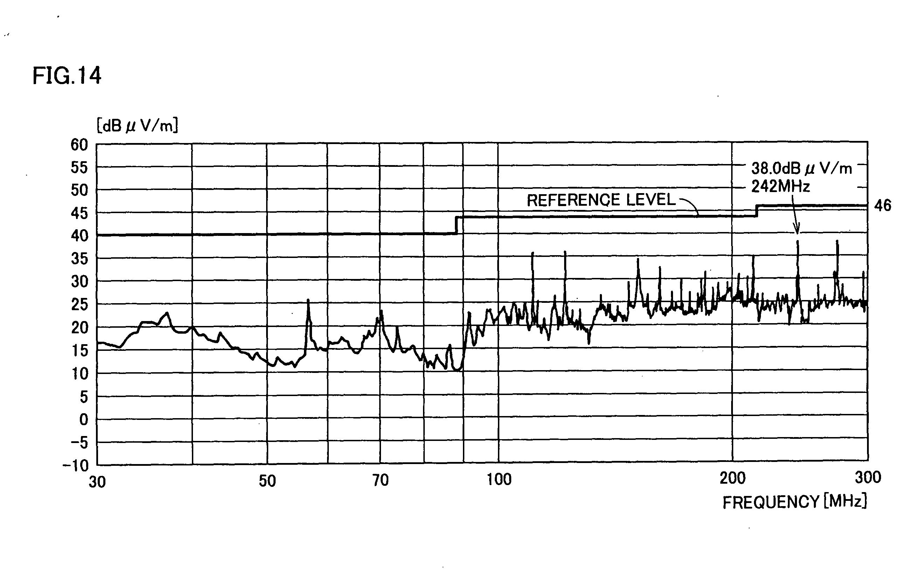

Fig. 14 represents the level of unwanted emission in a DVD apparatus when the digital circuit board of the present invention is employed.

It is appreciated from Fig. 14 that the unwanted emission is suppressed below the reference level in the frequency range of 30 MHz-300 MHz In particular, consider the unwanted emission in comparison with that of the evaluation example of Fig. 8. Although accurate comparison is not available since the horizontal direction is based on a logarithmic scale, the unwanted emission level is reduced to 38.0 (dBµ V/m) at the frequency of 242 MHz where the peak has exceeded the reference value significantly in Fig. 8.

As described above, the level of unwanted emission is reduced significantly by modifying the division of the grounding pattern of the digital circuit board and arranging filters adjacent to the connector. Accordingly, a metal case is dispensable, and a resin case can be employed. Therefore, the cost of the DVD apparatus can be reduced.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A DVD apparatus comprising:
a first printed circuit board (30) including a power supply circuit providing a direct current power supply voltage used internally,
an optical disk loader (20) including a pickup to read out information from an optical disk,
a second printed circuit board (40) including a digital circuit receiving supply of said direct current power supply voltage from said first printed circuit board to carry out a reproduction process of a video signal and an audio signal on a signal read out from said pick up and providing control of a system, and
a resin case (102) storing said first printed circuit board, said optical disk loader, and said second printed circuit board.

2. The DVD apparatus according to claim 1, wherein
a system LSI (50) integrated with a digital circuit that carries out said reproduction process and that carries out said control of a system is mounted on a surface side of said second printed circuit board, and
said second printed circuit board comprises a grounding pattern (141) arranged so as to overlap with at least a mounted region of said system LSI.

3. The DVD apparatus according to claim 2, wherein said grounding pattern is formed at an intermediate conductor layer between said surface side and a back side of said second printed circuit board.

4. The DVD apparatus according to claim 2, wherein said optical disk loader further comprises a motor (24) to rotate said optical disk,
wherein said second printed circuit board further comprises
a memory (41) connected to said system LSI, and
a motor driver (42) driving said motor,
wherein said grounding pattern (141) applies a common ground potential to said system LSI, said memory, and said motor driver.

5. The DVD apparatus according to claim 1, wherein
said second printed circuit board is of a shape having two pairs of opposite sides, and includes a system LSI (50) integrated with a digital circuit carrying out said reproduction process and providing said control of a system,
a mounting position of said system LSI on said second printed circuit board is located closer to a first side than a second side, said first and second sides consisting one of said two pairs of opposite sides,
said second printed circuit board further includes a connector (47) provided along said second side to establish electrical connection with said first printed circuit board.

6. The DVD apparatus according to claim 1, further comprising:
a connector (47) provided on said second printed circuit board, and
a signal line connected to said connector,
wherein said second printed circuit board comprises a region (137) for filter arrangement adjacent to a terminal of said connector connected to said signal line to prevent radiation of unwanted emission caused by a high frequency signal issued from said digital circuit.

7. The DVD apparatus according to claim 1, wherein said optical disk loader (20) is arranged at a central region, and said first printed circuit board (30) and said second printed circuit board (40) are arranged at respective sides of said optical disk loader.
